(19) Europäisches Patentamt
European Patent Office
Office européen des brevets

(11) EP 2 078 765 B1

(12) # EUROPEAN PATENT SPECIFICATION

(45) Date of publication and mention of the grant of the patent:
**11.05.2011 Bulletin 2011/19**

(21) Application number: **07828745.5**

(22) Date of filing: **28.09.2007**

(51) Int Cl.:
***C23C 14/24** (2006.01)*
***C08K 5/541** (2006.01)*
***C08L 83/04** (2006.01)*
***G02B 1/10** (2006.01)*

(86) International application number:
**PCT/JP2007/069004**

(87) International publication number:
**WO 2008/038782 (03.04.2008 Gazette 2008/14)**

(54) **VAPOR DEPOSITION MATERIAL, PROCESS FOR PRODUCING OPTICAL MEMBER OR PLASTIC LENS FOR SPECTACLE WITH USE THEREOF, AND PLASTIC LENS FOR SPECTACLE**

DAMPFABSCHEIDUNGSMATERIAL, VERFAHREN ZUR HERSTELLUNG EINES OPTISCHEN ELEMENTS ODER EINER KUNSTSTOFFLINSE FÜR EINE BRILLE UNTER VERWENDUNG DAVON UND KUNSTSTOFFLINSE FÜR BRILLE

MATÉRIAU DE DÉPÔT PAR ÉVAPORATION SOUS VIDE, PROCÉDÉ DE PRODUCTION D'UN ÉLÉMENT OPTIQUE OU LENTILLE EN PLASTIQUE POUR LUNETTE AVEC UTILISATION DE CELUI-CI, ET LENTILLE EN PLASTIQUE POUR LUNETTE

(84) Designated Contracting States:
**AT BE BG CH CY CZ DE DK EE ES FI FR GB GR HU IE IS IT LI LT LU LV MC MT NL PL PT RO SE SI SK TR**

(30) Priority: **29.09.2006 JP 2006269295**

(43) Date of publication of application:
**15.07.2009 Bulletin 2009/29**

(73) Proprietor: **Hoya Corporation**
**Tokyo 161-8525 (JP)**

(72) Inventors:
- **MITSUISHI, Takeshi**
  **Shinjyuku-ku**
  **Tokyo 161-8525 (JP)**
- **KAMURA, Hitoshi**
  **Shinjyuku-ku**
  **Tokyo 161-8525 (JP)**
- **SHINDE, Kenichi**
  **Shinjyuku-ku**
  **Tokyo 161-8525 (JP)**
- **TAKAHASHI, Yukihiro**
  **Shinjyuku-ku**
  **Tokyo 161-8525 (JP)**

(74) Representative: **Albrecht, Thomas**
**Kraus & Weisert**
**Patent- und Rechtsanwälte**
**Thomas-Wimmer-Ring 15**
**80539 München (DE)**

(56) References cited:
**EP-A2- 1 306 695**
**JP-A- 10 292 151**
**JP-A- 2003 202 407**
**JP-A- 2004 145 283**
**US-A1- 2004 047 047**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

EP 2 078 765 B1

## Description

### TECHNICAL FIELD

The present invention relates to a material for vapor deposition, an optical member using the material, a process for producing a plastic lens for spectacles and a plastic lens for spectacles produced in accordance with the process, and more particularly, to a process for producing an optical member having a thin film exhibiting the water-repelling property (hereinafter, referred to as a water-repelling film, occasionally) which exhibits an improved slipping property, enables to easily wipe off dirt attached to the optical member and exhibits improved durability and abrasion resistance, a process for producing a plastic lens for spectacles, a plastic lens for spectacles produced in accordance with the process and a material for vapor deposition used for the optical member, the plastic lens for spectacles and the processes.

### BACKGROUND ART

An antireflection film formed on an optical member such as a lens is, in general, formed with an inorganic oxide such as $ZrO_2$ and $SiO_2$. Therefore, dirt derived from sweat and finger prints tends to be attached to the film, and removal of the attached dirt is difficult. To overcome the above problem, for example, a method in which a thin film exhibiting the water-repelling property is formed on an antireflection film from a solution diluted with m-xylene hexachloride in accordance with the vacuum vapor deposition process, is disclosed in Patent Reference 1. In Patent Reference 1, a method in which a porous material obtained by sintering a metal powder exhibiting a great heat conductivity such as copper is impregnated with a fluid for the water-repelling treatment obtained by diluting a silazane-based organosilicon compound having fluorine with a fluorine-based solvent such as xylylene hexafluoride and trichloromonofluoromethane, and the obtained product is vapor deposited on an optical member by heating under a vacuum to form a film, is also disclosed. In Patent References 2 to 5, water-repelling agents comprising organosilicon compounds having fluorine other than the compound described above are disclosed. However, further improvements in the properties have been desired for the water-repelling films obtained by using the above water-repelling agents.

In particular, since the water-repelling film is formed as the outermost layer of an optical member, the water-repelling property is degraded with time due to wiping off of dirt attached to the surface and influences from the environment. Therefore, it is desired that the water-repelling property is maintained for a long time. It is also desired that finger prints and sebum can be easily wiped off when the dirt is attached to the optical face since a considerable time and repeated operations have been necessary to wipe off dirt.

Also US 2004/0047047 A1 discloses a material for vapour deposition which comprises an organosilicon compound having an alkyl group substituted with fluorine, used in a layer deposited by PVD onto plastic lenses.

[Patent Reference 1] Japanese Patent Application Laid-Open No. Heisei 5(1993)-215905
[Patent Reference 2] Japanese Patent Application Laid-Open No. Heisei 9(1997)-157582
[Patent Reference 3] Japanese Patent Application Laid-Open No. Heisei 9(1997)-202648
[Patent Reference 4] Japanese Patent Application Laid-Open No. Heisei 9(1997)-263728
[Patent Reference 5] Japanese Patent Application Laid-Open No. 2004-145283

### DISCLOSURE OF THE INVENTION

[Problems to be Overcome by the Invention]

The present invention has been made to overcome the above problems and has an object of providing processes for producing an optical member and a plastic lens for spectacles having a thin film exhibiting the water-repelling property which exhibits improved slipping property in combination with improved durability and abrasion resistance from those of conventional water-repelling films, a plastic lens for spectacles produced in accordance with the process and a material for vapor deposition used for the optical member, the plastic lens for spectacles and the processes.

[Means for Overcoming the Problems]

As the result of intensive studies by the present inventors to achieve the above object, it was found that the above object could be achieved when a substance having a complicated steric structure was formed by coupling a modified silicone oil represented by general formula (III) with a silane compound represented by general formula (II), and a mixture obtained by dispersing an organosilicon compound having an alkyl group having fluorine which is represented by general formula (I) in the formed substance was vapor deposited on a substrate by heating to form a thin film. The present invention has been completed based on the knowledge.

The present invention provides a material for vapor deposition which is obtained by mixing an organosilicon compound having an alkyl group substituted with fluorine which is represented by following general formula (I), a silane compound represented by following general formula (II) and a modified silicone oil represented by following general formula (III); a process for producing an optical member which comprises a step of solidifying the material for vapor deposition described above by heating and a step of vapor depositing the solidified material for vapor deposition on a substrate made of a plastics by heating by a heating means to form a thin film exhibiting water-repelling property; a process for producing a plastic lens for spectacles which comprises producing the plastic lens for spectacles in accordance with the process for producing an optical member described above, wherein the optical member is the plastic lens for spectacles; and a plastic lens for spectacles which is produced in accordance with the process.

General formula (I) is:

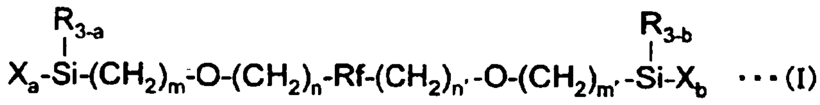

wherein Rf represents a divalent group having a perfluoropolyalkylene ether structure which comprises a unit represented by $-(C_kF_{2k}O)-$, k representing an integer of 1 to 6, and is linear with no branches, R each independently represent a monovalent hydrocarbon group having 1 to 8 carbon atoms, X each independently represent a hydrolyzable group or a halogen atom, n and n' each represent an integer of 0 to 2, m and m' each represent an integer of 1 to 5, and a and b each represent 2 or 3.

General formula (II) is:

$$R'\text{-}Si(OR'')3 \text{ and/or } Si(OR'')_4 \qquad (II)$$

wherein R' represents an organic group, and R" represents an alkyl group

General formula (III) is:

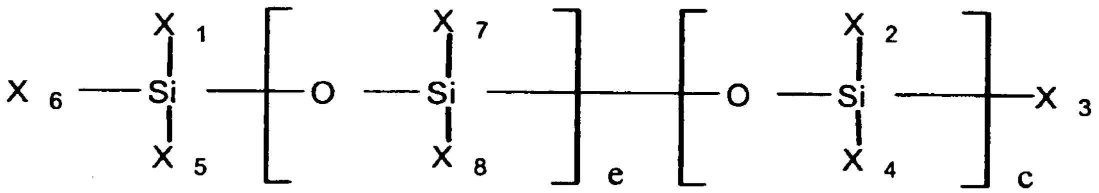

wherein c represents an integer of 1 or greater, e represents an integer of 0 or greater, $X_1$ to $X_8$ each independently represent an organic group, and groups represented by $X_1$ and $X_5$ and/or groups represented by $X_2$ and $X_4$ have methyl group.

THE EFFECT OF THE INVENTION

When the material for vapor deposition of the present invention is used, a thin film, an optical member and a plastic lens for spectacles in which the water-repelling film exhibits a decreased dynamic friction coefficient, provides excellent slipping feel, easily enables to wipe off attached dirt and exhibits excellent durability and abrasion resistance, can be obtained.

BRIEF DESCRIPTION OF THE DRAWINGS

Figure 1 shows a schematic diagram exhibiting the apparatus for conducting the durability test in the present invention. In the Figure, reference numerals mean as follows:

1: A lens
2: A cloth for cleaning a lens

3: A plate of a hexahedron

THE MOST PREFERRED EMBODIMENT TO CARRY OUT THE INVENTION

The material for vapor deposition of the present invention is a material obtained by mixing an organosilicon compound having an alkyl group substituted with fluorine which is represented by the following general formula (I), a silane compound represented by the following general formula (II) and a modified silicone oil represented by the following general formula (III).

General formula (I) is:

$$X_a\text{-}\overset{\overset{\large R_{3\text{-}a}}{|}}{Si}\text{-}(CH_2)_m\text{-}O\text{-}(CH_2)_n\text{-}Rf\text{-}(CH_2)_{n'}\text{-}O\text{-}(CH_2)_{m'}\text{-}\overset{\overset{\large R_{3\text{-}b}}{|}}{Si}\text{-}X_b \quad \cdots (I)$$

In general formula (I), Rf represents a divalent group having a perfluoropolyalkylene ether structure which comprises a unit represented by $-(C_kF_{2k}O)-$, k representing an integer of 1 to 6 and preferably 1 to 4, and is linear with no branches. The arrangement of the unit represented by $-(C_kF_{2k}O)-$ in the structure is random. When n and n' in general formula (I) both represent 0, the ends of the group represented by Rf bonded to oxygen atoms (O) in general formula (I) are not oxygen atom. Examples of the group represented by Rf include groups represented by the following general formulae:

$$-CF_2CF_2O(CF_2CF_2CF_2O)_1CF_2CF_2-$$

wherein 1 represents an integer of 1 or greater, preferably 1 to 50 and more preferably 10 to 40; and

$$-CF_2(OC_2F_4)_p-(OCF_2)_q-$$

wherein p and q each represent an integer of 1 or greater, preferably 1 to 50 and more preferably 10 to 40, the sum of p and q, p+q, represents an integer of 10 to 100, preferably 20 to 90 and more preferably 40 to 80, and the arrangement of the repeating units $(OC_2F_4)$ and $(OCF_2)$ in the general formula is random. However, the group represented by Rf is not limited to the groups shown above as the examples.

In general formula (I), X represents a hydrolyzable group or a halogen atom. When X represents a hydrolyzable group, examples of the hydrolyzable group represented by X include alkoxy groups such as methoxy group; ethoxy group, propoxy group and butoxy group; alkoxyalkoxy groups such as methoxymethoxy group, methoxyethoxy group and ethoxyethoxy group; alkenyloxy groups such as allyloxy group and isopropenoxy group, acyloxy groups such as acetoxy group, propionyloxy group, butylcarbonyloxy group and benzoyloxy group; ketoxime groups such as dimethylketoxime group, methylethylketoxime group, diethylketoxime group, cyclopentanoxime group and cyclohexanoxime group; amino groups such as N-methylamino group, N-ethylamino group, N-propylamino group, N-butylamino group, N,N-dimethylamino group, N,N-diethylamino group and N-cyclohexylamino group; amido groups such as N-methylacetoamido group, N-ethylacetoamido group and N-methylbenzamido groups; and aminooxy groups such as N,N-dimethylaminooxy group and N,N-diethylaminooxy group.

When X represents a halogen atom, examples of the halogen atom represented by X include chlorine atom, bromine atom and iodine atom.

Among these groups and atoms, methoxy group, ethoxy group, isopropenoxy group and chlorine atom are preferable, and methoxy group, ethoxy group and isopropenoxy group are more preferable from the standpoint of tight adhesion with the antireflection film.

In general formula (I), R represents a monovalent hydrocarbon group having 1 to 8 carbon atoms. When a plurality of R are present, the plurality of R may represent the same group or different groups. Examples of the group represented by R include alkyl groups such as methyl group, ethyl group, propyl group, butyl group, pentyl group, hexyl group, heptyl group and octyl group; cycloalkyl groups such as cyclopentyl group and cyclohexyl group; aryl groups such as phenyl group, tolyl group and xylyl group; aralkyl groups such as benzyl group and phenethyl group; and alkenyl groups such as vinyl group, allyl group, butenyl group, pentenyl group and hexenyl group. Among these groups, monovalent hydrocarbon groups having 1 to 3 carbon atoms are preferable, and methyl group is more preferable.

In general formula (I), n and n' each represent an integer of 0 to 2 and preferably 1. n and n' may represent the same integer or different integers. m and m' each represent an integer of 1 to 5 and preferably 3. m and m' may represent the same integer or different integers.

a and b each represent 2 or 3 and preferably 3 from the standpoint of the reactivity in hydrolysis and condensation and tight adhesion with the antireflection film.

The molecular weight of the silane modified with a perfluoropolyalkylene ether which is represented by general formula (I) is not particularly limited. It is suitable that the molecular weight is 500 to 20,000 and preferably 1,000 to 10,000 expressed as the number-average molecular weight from the standpoint of stability and easiness of handling.

Examples of the silane modified with a perfluoropolyalkylene ether which is represented by general formula (I) include compounds represented by the following structural formulae. However, the above silane is not limited to the compounds shown as the examples.

$(CH_3O)_3SiCH_2CH_2CH_2OCH_2CF_2CF_2O(CF_2CF_2CF_2O)_1CF_2CF_2\text{-}CH_2OCH_2CH_2CH_2Si(OCH_3)_3$

$(CH_3O)_2CH_3SiCH_2CH_2CH_2OCH_2CF_2CF_2O(CF_2CF_2CF_2O)_1CF_2\text{-}CF_2CH_2OCH_2CH_2CH_2SiCH_3(OCH_3)_2$

$(CH_3O)_3SiCH_2CH_2CH_2OCH_2CF_2(OC_2F_4)p(OCF_2)_qOCF_2CH_2OCH_2\text{-}CH_2CH_2Si(OCH_3)_3$

$(CH_3O)_2CH_3SiCH_2CH_2CH_2OCH_2CF_2(OC_2F_4)_p(OCF_2)_qOCF_2CH_2O\text{-}CH_2CH_2CH_2Si\ CH_3\ (OCH_3)_2$

$(CH_3O)_3SiCH_2CH_2CH_2OCH_2CH_2CF_2(OC_2F_4)_p(OCF_2)_qOCF_2CH_2\text{-}CH_2OCH_2CH_2CH_2Si(OCH_3)_3$

$(C_2H_5O)_3SiCH_2CH_2CH_2OCH_2CF_2(OC_2F_4)_p(OCF_2)_qOCF_2CH_2O\text{-}CH_2CH_2CH_2Si(OC_2H_5)_3$

The compound represented by general formula (I) may be used singly or in combination of two or more. Occasionally, the silane modified with a perfluoropolyalkylene ether described above may be used in combination with a product of condensation with partial hydrolysis of the modified silane.

It is preferable that the silane modified with a perfluoropolyalkylene ether which is represented by general formula (I) is used after being diluted with a solvent. Examples of the solvent used for the dilution include aliphatic hydrocarbon-based solvents modified with fluorine (such as perfluoroheptane, perfluorooctane and perfluoroether), aromatic hydrocarbon-based solvents modified with fluorine (such as 1,3-di(trifluoromethyl)benzene and trifluoromethylbenzene), ether-based solvents modified with fluorine (such as methyl perfluorobutyl ether and perfluoro(2-butyltetrahydrofuran), alkylamine-based solvents modified with fluorine (such as perfluorotributylamine and perfluorotripentylamine), hydrocarbon-based solvents (such as petroleum benzine, mineral spirits, toluene and xylene) and ketone-based solvents (such as acetone, methyl ethyl ketone and methyl isobutyl ketone). The solvent may be used singly or in combination of two or more. Among these solvents, solvents modified with fluorine are preferable from the standpoint of the solubility of the modified silane and the wetting property, and perfluoroether, 1,3-di(trifluoromethyl)benzene, perfluoro(2-butyltetrahydrofuran) and perfluorotributylamine are more preferable.

General formula (II) is:

$$R'\text{-}Si(OR'')_3 \text{ and/or } Si(OR'')_4 \qquad \text{(II)}$$

In general formula (II), R' represents an organic group, and OR" represents a hydrolyzable group.

Examples of the group represented by R' include alkyl groups having 1 to 50 carbon atoms (preferably 1 to 10 carbon atoms) (such as methyl group, ethyl group and propyl group) and the alkyl groups described above having organic functional groups (functional groups reactive with organic materials). Examples of the organic functional group include epoxy group, glycidyl group, amino group, glycidoxy group and isocyanate group. Among these groups, glycidoxy group and amino group are preferable.

In general formula (II), R" represents an alkyl group having 1 to 48 carbon atoms (such as methyl group, ethyl group and propyl group) and preferably methyl group or ethyl group.

The silane compound represented by general formula (II) may be a compound having a structure obtained by condensation of a plurality of the silane compounds. For example, the silane compound may be a compound having a structure in which the group represented by R' has the structure represented by $Si(OR'')_3$ such as the structure represented by $(C_2H_5O)_3Si\text{-}O\text{-}Si(OC_2H_5)_3$ shown in the following.

Examples of the silane compound represented by general formula (II) include compounds expressed by the formulae: $(C_2H_5O)_3SiC_3H_6NH_2$, $(CH_3O)_3SiC_3H_6NH_2$, $(C_2H_5O)_4Si$ and $(C_2H_5O)_3Si\text{-}O\text{-}Si(OC_2H_5)_3$ and 3-glycidoxypropyltriethoxysilane. However, the silane compound is not limited to the compounds shown as the examples.

The compound represented by general formula (II) may be used singly or in combination of two or more.

It is preferable that, as the compound represented by general formula (II), the compound represented by $R'\text{-}Si(OR'')_3$ is used singly or in an amount greater than other components. In this case, the reaction product with the modified silicone oil represented by general formula (III) has a more complicated steric structure, and durability and abrasion resistance are improved.

General formula (III) is:

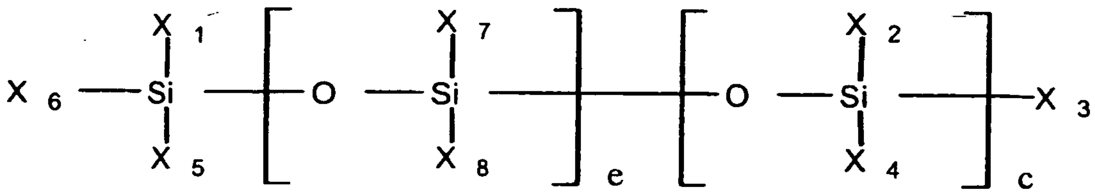

In general formula (III), c represents an integer of 1 or greater, preferably 1 to 60 and more preferably 1 to 10, and e represents an integer of 0 or greater, preferably 1 to 10 and more preferably 1 to 3.

In general formula (III), $X_1$ to $X_8$ each independently represent an organic group. Examples of the organic group include alkyl groups having 1 to 20 carbon atoms (such as methyl group, ethyl group and propyl group), epoxy group, glycidyl group, amino group, carboxyl group and alkoxy groups. These groups may be substituted.

In general formula (III), it is preferable that the organic groups at both ends of the main chain (the siloxane chain) (groups represented by $X_3$ and $X_6$) has epoxy group, glycidyl group, amino group or an alkoxy group and more preferably glycidyl group or amino group. It is preferable that the organic groups at the side chains (groups represented by $X_7$ and/or $X_8$) has epoxy group, glycidyl group, amino group or isocyanate group and more preferably glycidyl group or amino group.

It is more preferable that the compound represented by general formula (III) has the organic groups described above at both ends and at the side chains in combination. In this case, it is preferable that the organic groups at both ends (groups represented by $X_3$ and $X_6$) have alkoxyl groups, and one of the organic groups at the side chains (the group represented by $X_7$ or $X_8$) has glycidyl group or amino group. It is preferable that, when the organic group has epoxy group, the group represented by R' in general formula (II) has amino group, and when the organic group has amino group, the group represented by R' in general formula (II) has epoxy group.

In general formula (III), groups represented by $X_1$ and $X_5$ and/or groups represented by $X_2$ and $X_4$ have methyl group.

Examples of the modified silicone oil represented by general formula (III) include compounds having the structures shown in the following. However, the modified silicone oil represented by general formula (III) is not limited to the compounds shown as the examples.

(a)

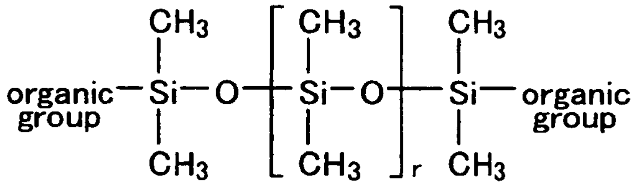

organic group

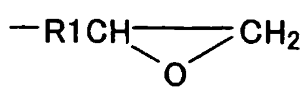

(b)

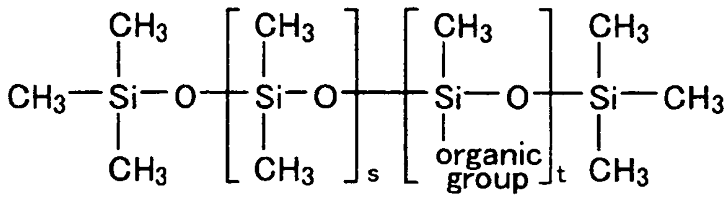

organic group

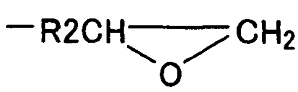

(c)

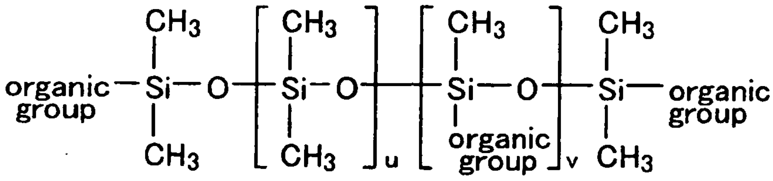

organic group
$-R3NH_2$ (side chain)
-OR4 (both chain ends)

Compounds shown in (a) are compounds represented by general formula (III) in which e represents 0, the organic groups at both ends of the main chain (groups represented by $X_3$ and $X_6$) have epoxy group, and the other organic groups ($X_1$, $X_2$, $X_4$ and $X_5$) are methyl group.

Compounds shown in (b) are compounds represented by general formula (III) in which e represents a number represented by t, c represents a number represented by (s+1), the organic group at one of the side chains (represented by one of $X_7$ and $X_8$) has epoxy group, and the other organic groups (represented by $X_1$, $X_2$, $X_3$, $X_4$, $X_5$, $X_6$ and the rest of $X_7$ and $X_8$) are methyl group.

Compound shown in (c) are compounds represented by general formula (III) in which e represents a number represented by v, c represents a number represented by (u+1), the organic groups at both chain ends of the main chain (represented by $X_3$ and $X_6$) have alkoxy groups, the organic group at one of the side chains (represented by one of $X_7$ and $X_8$) has amino group, and the other organic groups (represented by $X_1$, $X_2$, $X_4$, $X_5$ and the rest of $X_7$ and $X_8$) are methyl group.

In the organic groups in the compounds shown in (a) and (b), R1 and R2 each represent an alkylene group (such as methylene group, ethylene group and propylene group), r represents an integer of 1 to 20, s represents an integer of 1 to 20, and t represents an integer of 1 to 40.

In the organic groups in the compounds shown in (c), R3 represents an alkylene group (such as methylene group, ethylene group and propylene group), R4 represents an alkyl group (such as methyl group, ethyl group and propyl group), u represents an integer of 1 to 40, and v represents an integer of 1 to 20.

The compounds represented by general formula (III) may be used singly or in combination of two or more.

When the vapor deposition is conducted using the organosilicon compound having an alkyl group substituted with fluorine which is represented by_general formula (I) singly as the material for vapor deposition, durability and abrasion resistance are poor since bonds within the organosilicon compound having an alkyl group substituted with fluorine and bonding with the substrate are weak. In contrast, when the organosilicon compound having an alkyl group substituted with fluorine which is represented by general formula (I) is mixed with the silane compound represented by general formula (II) and the modified silicone oil represented by general formula (III), and the vapor deposition is conducted using the mixture as the material for vapor deposition, durability and abrasion resistance of the obtained thin film are improved. The improvement is considered to be obtained since compounds having a complicated steric structure is formed by bonding the modified silicone oil represented by general formula (III) with the silane compound represented by general formula (II) which is a silane coupling agent, and the organosilicon compound having an alkyl group substituted with fluorine which is represented by general formula (I) is protected with the reaction product of the silane compound represented by general formula (II) and the modified silicone oil represented by general formula (III) in the condition formed by the vapor deposition. It is more preferable that the silane compound represented by general formula (II) and the modified silicone oil represented by general formula (III) are mixed and brought into reaction with each other in advance, and the organosilicon compound having an alkyl group substituted with fluorine which is represented by general formula (I) is mixed with the reaction product. This process is more preferable since the organosilicon compound having an alkyl group substituted with fluorine which is represented by general formula (I) does not adversely affect the reaction between the silane compound represented by general formula (II) and the modified silicone oil represented by general formula (III). More specifically, the silane compound represented by general formula (II) and the modified silicone oil represented by general formula (III) are mixed and brought into reaction with each other by stirring, for example, for 1 to 168 hours to form a skeleton substance. Then, the organosilicon compound which is represented by general formula (I) is dispersed into the reaction product, and the material for vapor deposition of the present invention is obtained.

When one of the group represented by R' in general formula (II) and - the organic group in general formula (III) has amino group and the other has epoxy group, examples of the skeleton substance obtained by the reaction of the silane compound represented by general formula (II) and the modified silicone oil represented by general formula (III) include mixtures of secondary amine compounds and tertiary amine compounds. Specific examples of the above skeleton substance include substances having the following structures:

secondary amine compound

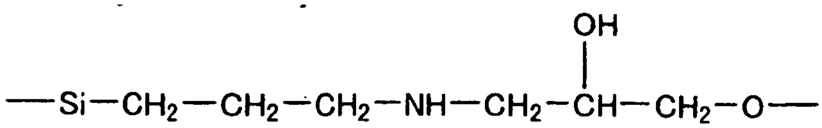

tertiary amine compound

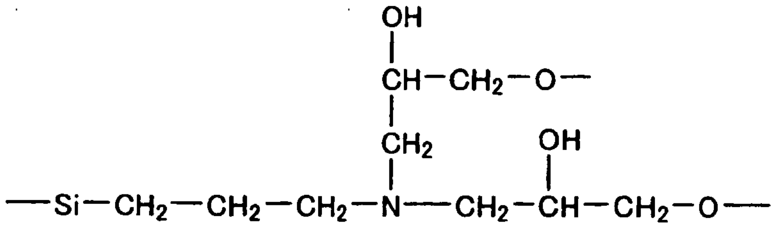

The ratios of the secondary amine compound and the tertiary amine compound are approximately the same. For example, ethoxy group is bonded to the left side end of -Si-, and dimethylsiloxane structure is bonded to the right side end.

The process for producing an optical member of the present invention comprises a step of solidifying the material for vapor deposition described above by heating and a step of vapor depositing the solidified material for vapor deposition on a substrate made of a plastics by heating by a heating means to form a thin film exhibiting the water-repelling property.

The material for vapor deposition of the present invention has a great viscosity since the molecular weight is increased by the reaction of the modified silicone oil represented by general formula (III) and the silane compound represented by general formula (II). When the material for vapor deposition is used after impregnating a porous material with the material, occasionally, the material for vapor deposition does not penetrate into the porous material easily. To obtain a uniform film by vapor deposition, it is preferable that a liquid material for vapor deposition is solidified (to achieve a condition such that the material does not flow out of a porous material or a container and is not tacky on touching). This is not limited to the case where the material for vapor deposition is used after impregnation of a porous material as described above. However, the above material for vapor deposition is not easily solidified. It is considered that the above phenomenon arises by the influence of the small volatility of the solvent used for dilution of the organosilicon compound having an alkyl group substituted with fluorine which is represented by general formula (I) even under heating.

In the material for vapor deposition of the present invention, it is preferable that the dilution is conducted using a fluorine-based solvent which exhibits small kinematic viscosity and great volatility and is substantially inert to other components. When the above fluorine-based solvent is used, the viscosity of the reaction product of the silane compound represented by general formula (II) and the modified silicone oil represented by general formula (III) can be decreased. Therefore, penetration into the porous material can be improved, and the solidification of the material for vapor deposition can be facilitated. It is considered that the fluorine-based solvent described above exhibits also the effect of decreasing the amount of the solvent added to the organosilicon compound having an alkyl group substituted with fluorine which is represented by general formula (I) when the fluorine-based solvent is vaporized. As the fluorine-based solvent, hydrofluoroethers represented by the following general formula (IV) are preferable:

$$CF_3\text{-}(CF_2)_d\text{-}OR''' \qquad (IV)$$

In general formula (IV), d represents an integer of 1 to 50, and R'" represents methyl group or ethyl group. It is preferable that d represents an integer of 1 to 20 and more preferably 1 to 10.

Examples of the hydrofluoroether represented by general formula (IV) include compounds represented by the formulae: $C_4F_9OCH_3$, $C_4F_9OC_2H_5$, $C_6F_{13}OCH_3$ and $C_6H_{13}OC_2H_5$. However, the hydrofluoroether is not limited to the compounds shown as the examples.

The compound represented by general formula (IV) may be used singly or in combination of two or more.

To the material for vapor deposition of the present invention, other solvents and perfluoropolyethers which do not have silicon atom may be added in combination with the hydrofluoroether represented by general formula (IV).

The hydrofluoroether represented by general formula (IV) is preferable as the fluorine-based solvent, because the hydrofluoroether is inert to other components and great volatility, the hydrofluoroether evaporates by heating the material for vapor deposition comprising the hydrofluoroether, and the component represented by general formula (I) to (III) become hard.

As for the relative amounts of the components in the material for vapor deposition of the present invention, the amount of the organosilicon compound having an alkyl group substituted with fluorine which is represented by general formula (I) in a concentration of 20% by mass is 30 to 95% by mass (preferably 50 to 85% by mass), the amount of the silane compound represented by general formula (II) is 1 to 50% by mass (preferably 10 to 40% by mass), the amount of the modified silicone oil represented by general formula (II) is 1 to 50% by mass (preferably 10 to 40% by mass), and the amount of the hydrofluoroether represented by general formula (IV) is 0 to 50% by mass (preferably 5 to 40% by mass). The sufficient effect can be obtained when the amounts are within the above ranges.

The material for vapor deposition of the present invention is used in the form of a solution. Where necessary, the fluorine-based solvent such as the hydrofluoroether represented by general formula (IV), other solvents and perfluoropolyether having no silicon atom may be mixed into the solvent. Although the solution may be placed into a container and heated, it is preferable from the standpoint of obtaining many uniformly vapor deposited films that the material for vapor deposition is used after impregnating a porous material with the material. It is preferable that a sintered filter obtained by sintering powder of a metal exhibiting a great heat conductivity such as copper and stainless steel is used as the porous material. It is suitable from the standpoint of obtaining a suitable rate of vapor deposition that the porous material has a mesh of 40 to 200 $\mu$m and preferably 80 to 120 $\mu$m.

It is preferable that the material for deposition is used in the form solidified by heating preferably after the fluorine-based solvent is added either when the solution is placed directly in a container or when the solution is used after impregnating the porous material with the solution. The temperature of the solidification is set at a temperature in the range such that the material for vapor deposition is not decomposed. It is preferable that the temperature is 50 to 100°C and more preferably 70 to 90°C. It is preferable that the time of heating is 60 minutes or longer and more preferably 60 to 180 minutes. As the means for heating, a means such as a dry oven can be used.

In the process for producing an optical member of the present invention, the material for vapor deposition described above is vapor deposited on a substrate having an antireflection film in accordance with the vapor deposition by heating (using a halogen heater, a resistance heater or an electron gun) under a reduced pressure. When the vapor deposition is conducted in accordance with the vapor deposition by heating using an electron gun, a thin film exhibiting an excellent accuracy can be formed. The degree of vacuum in the apparatus for vacuum vapor deposition is not particularly limited. From the standpoint of obtaining a uniform water-repelling film, it is preferable that the degree of vacuum is $1.33\times10^{-1}$ to $1.33\times10^{-6}$ Pa ($10^{-3}$ to $10^{-8}$ Torr) and more preferably $6.66\times10^{-1}$ to $8.00\times10^{-4}$ Pa ($5.0\times10^{-3}$ to $6.0\times10^{-6}$ Torr).

In the present invention, the specific temperature in the heating of the material for vapor deposition is different depending on the type of the material for vapor deposition and the condition of vacuum in the vapor deposition. It is preferable that the vapor deposition is conducted at a temperature in the range from the temperature of the start of the vapor deposition of the material for vapor deposition to a temperature not exceeding the temperature of decomposition of the material for vapor deposition under the desired degree of vacuum. The temperature of the start of the vapor deposition means the temperature at which the vapor pressure of the solution containing the material for vapor deposition described above becomes the same as the degree of vacuum. The temperature of decomposition of the material for vapor deposition means the temperature at which 50% by mass of the material for vapor deposition described above is decomposed within 1 minutes (under the atmosphere of nitrogen in the absence of substances reactive with the compound).

The rate of vapor deposition is different depending on the method of heating. When an electron gun is used, it is preferable that the time from the start of heating the above organosilicon compound to the completion of the vapor deposition is 120 seconds or smaller, more preferably 50 seconds or smaller, still more preferably 40 seconds or smaller and most preferably 30 seconds or smaller under the condition such that the temperature is kept in the above range. The optical member having a water-repelling film exhibiting excellent durability can be provided by completing the vapor deposition at the temperature of heating within the above range in a short time, i.e., by providing the organosilicon compound with a great energy in a short time. When a water-repelling agent containing two components having temperatures of the start of vapor deposition different from each other to some degree is used, the vapor deposition can be completed approximately simultaneously and a uniform film can be obtained by selecting the temperature of vapor deposition in the range from the temperature of the start of vapor deposition of the raw material having a higher temperature of the start of vapor deposition to the temperature of decomposition of the raw material having a lower temperature of decomposition.

As the means for achieving the rate of vapor deposition described above, it is preferable that the organosilicon compound described above is irradiated with electron beams. For generating the electron beams, an electron gun conventionally used in vapor deposition apparatuses can be used. When the electron gun is used, the entire organosilicon compound can be irradiated with uniform energy, and formation of the uniform water-repelling film is facilitated. The power of the electron gun is different depending on the substances used, the apparatus for vapor deposition, the degree of vacuum and the area of irradiation. It is preferable that the voltage of acceleration is about 6 kV, and the applied electric current is about 5 to 40 mA.

It is preferable that the thin film exhibiting the water-repelling property formed in accordance with the present invention has a refractive index of 1.30 to 1.47 (preferably 1.40 to 1.45) and a thickness of 1 to 20 nm (preferably 3 to 15 nm). When the thickness is 3 nm or greater, sufficient durability and abrasion resistance can be obtained. When the thickness is 15 nm or smaller, there is no possibility that the transmittance is decreased due to cloudiness.

In the present invention, the optical member means not only a lens for spectacles but also an optical member in the broad meaning such as a camera lens, an optical filter attached to a display of a computer and a windshield glass of an automobile.

Examples of the substrate made of plastics used in the present invention include optical substrates made of plastics such as homopolymers of methyl methacrylate, copolymers of methyl methacrylate with one or more other monomers used as the monomer components, homopolymers of diethylene glycol bisallylcarbonate, copolymers of diethylene glycol bisallylcarbonate and one or more other monomers used as the monomer components, copolymers having sulfur, copolymers having halogens, polycarbonates, polystyrene, polyvinyl chloride, unsaturated polyesters, polyethylene terephthalate and polyurethanes; and optical substrates made of inorganic glasses. The substrate described above may have a hard coat layer on the substrate. Examples of the hard coat layer include cured films containing organosilicon compounds and acrylic compounds.

The antireflection film (the film formed by vapor deposition) means a film formed for decreasing reflection from the surface of an optical substrate such as a lens, which is a film having a single layer or a plurality of layers formed with a material such as $ZrO_2$, $SiO_2$, $TiO_2$, $Ta_2O_5$, $Y_2O_3$, $MgF_2$ and $Al_2O_3$ (preferably having a film of $SiO_2$ as the outermost layer) or a colored film of a material such as $CrO_2$ (preferably having a film of $SiO_2$ as the outermost layer). In the present invention, it is preferable that a layer containing silicon dioxide as the main component is used as the outermost layer of the antireflection film. The layer containing silicon dioxide as the main component means a layer substantially composed of silicon dioxide or a hybrid layer comprising silicon dioxide, aluminum oxide and organic compounds. It is preferable that the antireflection film is formed in accordance with the vapor deposition process.

EXAMPLES

The present invention will be described more specifically with reference to examples in the following. However, the present invention is not limited to the examples.

1. Preparation of a plastic lens having an antireflection film

As the plastic lens, a lens based on diethylene glycol bisallylcarbonate polymer (manufactured by HOYA CORP.; HI-LUX (a trade name); the refractive index: 1.499; the dioptic power: 0.00) was used. On the substrate of the plastic lens, a cured film disclosed in Japanese Patent Application Laid-Open No. Showa 63(1988)-10640 was formed. Specifically, to a solution prepared by adding 2.0 parts by mass of a 0.5 N hydrochloric acid and 20 parts by mass of acetic acid to 240 parts by mass of a colloidal silica having a concentration of $SiO_2$ of 40% (SNOWTEX-40; silica dispersed in water; manufactured by NISSAN CHEMICAL INDUSTRIES, Ltd.), 95 parts by mass of γ-glycidoxypropyltrimethoxysilane (a trifunctional organosilicon compound) was added dropwise while the above solution was stirred at 35°C, and the resultant mixture was stirred at the room temperature for 8 hours and left standing at the room temperature for 16 hours. To the obtained solution of a hydrolyzate, 80 parts by mass of methylcellosolve, 120 parts by mass of isopropyl alcohol, 40 parts by mass of butyl alcohol, 16 parts by mass of aluminum acetylacetonate, 0.2 parts by mass of a silicone-based surfactant (NUC SILWET Y-7006 (a trade name; manufactured by NIPPON UNICAR Co., Ltd.) and 0.1 part by mass of an UV absorbent (TINUVIN P (a trade name); manufactured by CIBA GEIGY Company) were added. After being stirred for 8 hours, the resultant mixture was aged for 24 hours, and a coating composition was obtained. The obtained coating composition was applied to the substrate in accordance with the dipping process at a speed of pulling up of 15 cm/min. After being left standing at the room temperature for 15 minutes, the formed coating film was cured by heating at 120°C for 2 hours, and a cured coating film was obtained.

Then, on the obtained coating film, an undercoat layer comprising silicon dioxide [the refractive index: 1.46; the thickness: 0.5λ (λ=550 nm)] was formed in accordance with the vacuum vapor deposition process (the degree of vacuum: $2.67 \times 10^{-3}$ Pa ($2 \times 10^{-5}$ Torr). On the formed undercoat layer, a first layer [the refractive index: 1.70; the thickness: 0.24λ] which was a three-layered equivalent film comprising a layer comprising titanium dioxide (the thickness: 0.06λ) obtained in accordance with the ion beam assist process in which the plastic lens was irradiated with oxygen ion beams, a layer comprising silicon dioxide (the thickness: 0.12λ) obtained in accordance with the vacuum vapor deposition process and a layer comprising titanium dioxide (the thickness: 0.06λ) obtained in accordance with the ion beam assist process, was formed. On the formed first layer, a second layer (the refractive index: 2.40; the thickness: 0.5λ) comprising titanium dioxide was formed in accordance with the ion beam assist process. On the formed second layer, a third layer [the refractive index: 1.46; the thickness: 0.25λ] comprising silicon dioxide was formed in accordance with the vacuum vapor deposition process (the degree of vacuum: $2.67 \times 10^{-3}$ Pa ($2 \times 10^{-5}$ Torr), and a plastic lens having an antireflection

film was obtained. The luminous reflectance of the obtained lens was 0.4%.

2. Evaluation of physical properties

Physical properties of plastic lenses obtained in Examples and Comparative Examples were evaluated in accordance with the method described in the following.

(1) Static contact angle with water

Using a contact angle meter (manufactured by KYOWA INTERFACE SCIENCE Co., Ltd.; the CA-D type), a droplet of water having a diameter of 2 mm was formed on the tip of a needle at 25°C and brought into contact with the uppermost portion of the convex face of a lens to form a liquid droplet. The angle between the formed droplet and the surface was measured and used as the static contact angle. When the radius of the droplet of water (the radius of the portion of the droplet of water contacting the surface of the lens) is represented by r, and the height of the droplet of water is represented by h, the static contact angle θ is obtained in accordance with the following equation:

$$\theta = 2\times\tan^{-1}(h/r)$$

The measurement of the static contact angle was conducted within 10 seconds after the droplet of water was brought into contact with the lens so that the error in the measurement caused by the vaporization of water was minimized.

(2) Appearance

The presence or the absence of unevenness of color and change of color in the interference color was examined by visual observation, and it was evaluated whether the lens had the appearance allowing the use as the spectacle lens.

(3) Durability

Using the apparatus shown in Figure 1, the surface of a plastic lens having a water-repelling film was rubbed with a lens cleaning cloth (the trade name: HOYA CLEARCLOTH) under application of a load of 500 g in 3,600 reciprocal movements (25°C; the relative humidity: 50 to 60%). Then, the static contact angle of water was measured in accordance with the method described in (1).

(4) Abrasion resistance

Using a reciprocal friction abrasion tester manufactured by SHINTO SCIENTIFIC Co., Ltd., the abrasion test of the surface of a plastic lens having a water-repelling film was conducted with a rubber eraser containing sand (manufactured by LION COMPANY; "GYAZA HANSUNA") in 50 reciprocal movements under application of a load of 4 kg. The haze was measured using a haze meter MH-150 manufactured by MURAKAMI COLOR RESERCH LABORAYORY, and the change in the haze was measured.

(5) Dynamic friction coefficient

Using a Continuous Loading Surface Property Tester type: 22H manufactured by SHINTO SCIENTIFIC Co., Ltd., the average dynamic friction coefficient in the distance of movement of 20 mm was measured 3 times, and the average value was obtained.

Preparation Example 1 (Preparation of Agent for water-repelling treatment 1 (a material for vapor deposition))

Agent for water-repelling treatment 1 as a material for vapor deposition was prepared as described in the following.

As the vessel for the preparation, a 30 cc glass screw bottle manufactured by AS-ONE Company was used, and the rotation speed of a stirrer was set at 500 rpm.

Table 1

| Step | Raw material | Amount | Time of mixing |
|---|---|---|---|
| 1 | KBE 903 + KF 105 | 10 g + 10 g | 24 hours |
| 2 | water-repelling agent + product of Step 1 | 15 g + 3.5 g | 24 hours |
| 3 | product of Step 2 + HFE 7200 | 18.5 g + 3 g | 24 hours |

(Step 1) Preparation of a reaction solution of a silane compound and a silicone oil

KBE 903 (a trade name; manufactured by SHIN-ETSU CHEMICAL Co., Ltd.; $(C_2H_5O)_3SiC_3H_6NH_2$, the molecular weight: 221.4; the refractive index (25°C): 1.420) as the silane compound represented by general formula (II) in an amount of 10 g and 10 g of KF 105 (a trade name; manufactured by SHIN-ETSU CHEMICAL Co., Ltd.; the kinematic viscosity: 15 $mm^2/s$ (25°C); the refractive index (25°C): 1.442; the equivalent of the functional group: 490 g/mole) having the structure shown in (a) as the silicone oil represented by general formula (III) were mixed, and the resultant mixture was stirred for 24 hours.

The above silane compound had amino group, and the above silicone oil had epoxy group. Therefore, the amino group and the epoxy group were brought into reaction with each other, and a mixture containing dimethylsiloxanes having secondary and tertiary amines was formed. About 24 hours was necessary for the reaction to be completed. It was confirmed by the analyses of H, C and NMR that compounds having a molecular weight of about 200 to 1,000 were formed.

(Step 2) Mixing of an organosilicon compound having an alkyl group substituted with fluorine (a water-repelling agent) and the reaction solution of the silane compound and the silicone oil

To 15 g of an organosilicon compound having the following structure:

$$(CH_3O)_3SiCH_2CH_2CH_2OCH_2CF_2(OC_2F_4)_p(OCF_2)_qOCF_2CH_2OCH_2\text{-}CH_2CH_2Si(OCH_3)_3$$

(wherein p=22, q=22, and the arrangement of the repeating units $(OC_2F_4)$ and $(OCF_2)$ was random) as the organosilicon compound having an alkyl group substituted with fluorine which is represented by general formula (I), 3.5 g of the solution prepared in Step 1 was added, and the resultant mixture was stirred for 24 hours.

(Step 3) Step of mixing a hydrofluoroether for improving the property for penetration and the property for drying

To 18.5 g of the mixed solution prepared in Step 2, 3 g of HFE 7200 (a trade name: manufactured by SUMITOMO 3M Ltd.; $C_4F_9OC_2H_5$; the viscosity: $5.7\times10^{-4}$ Pa·s; the kinematic viscosity: 0.40 $mm^2/s$; the refractive index (25°C): 1.28) as the hydrofluoroether represented by general formula (IV) was added, and the resultant mixture was stirred for 24 hours.

The thin film obtained from Agent for water repelling treatment 1 was constituted with a cured product having a three-dimensional structure formed by hydrolysis and condensation of the group represented by X in general formula (I) and a cured product having a three-dimensional structure formed by hydrolysis and condensation of the mixture of the compound represented by general formula (II) and the compound represented by general formula (III).

Preparation Example 2 (Preparation of Agent for water-repelling treatment 2 (a material for vapor deposition))

Agent for water-repelling treatment 2 as a material for vapor deposition was prepared as described in the following.

As the vessel for the preparation, a 30 cc glass screw bottle manufactured by AS-ONE Company was used, and the rotation speed of a stirrer was set at 500 rpm.

Table 2

| Step | Raw material | Amount | Time of mixing |
|---|---|---|---|
| 1 | water-repelling agent + KBE 903 + KF 105 | 15 g + 1.75 g + 1.75 g | 24 hours |
| 2 | product of Step 1 + HFE 7200 | 18.5 g + 3 g | 24 hours |

(Step 1) Preparation of a reaction solution of an organosilicon compound having an alkyl group substituted with fluorine, a silane compound and a silicone oil

To 15 g of an organosilicon compound having an alkyl group substituted with fluorine which had the following structure:

$$(CH_3O)_3SiCH_2CH_2CH_2OCH_2CF_2(OC_2F_4)_p(OCF_2)_qOCF_2CH_2OCH_2\text{-}CH_2CH_2Si(OCH_3)_3$$

(wherein p=22, q=22, and the arrangement of the repeating units ($OC_2F_4$) and ($OCF_2$) was random) as the organosilicon compound having an alkyl group substituted with fluorine which is represented by general formula (I), 1.75 g of KBE 903 (a trade name; manufactured by SHIN-ETSU CHEMICAL Co., Ltd.; $(C_2H_5O)_3SiC_3H_6NH_2$, the molecular weight: 221.4; the refractive index (25°C): 1.420) as the silane compound represented by general formula (II) and 1.75 g of KF 105 (a trade name; manufactured by SHIN-ETSU CHEMICAL Co., Ltd.; the kinematic viscosity: 15 $mm^2/s$; the refractive index (25°C): 1.442; the equivalent of the functional group: 490 g/mole) having the structure shown in (a) as the silicone oil represented by general formula (III) were mixed, and the resultant mixture was stirred for 24 hours.

The above silane compound had amino group, and the above silicone oil had epoxy group. Therefore, the amino group and the epoxy group were brought into reaction with each other even when the compound represented by general formula (II) and the compound represented by general formula (III) were simultaneously mixed with the organosilicon compound having an alkyl group substituted with fluorine which is represented by general formula (I), and a mixture of the organosilicon compound having an alkyl group substituted with fluorine with dimethylsiloxanes having secondary and tertiary amines was formed.

(Step 2) Step of mixing a hydrofluoroether for improving the property for penetration and the property for drying

To 18.5 g of the mixed solution prepared in Step 1, 3 g of HFE 7200 (a trade name: manufactured by SUMITOMO 3M Ltd.; $C_4F_9OC_2H_5$; the viscosity: $5.7\times10^{-4}$ Pa·s; the kinematic viscosity: 0.40 $mm^2/s$; the refractive index (25°C): 1.28) as the hydrofluoroether represented by general formula (IV) was added, and the resultant mixture was stirred for 24 hours.

The thin film obtained from Agent for water repelling treatment 2 was constituted with a cured product having a three-dimensional structure formed by hydrolysis and condensation of the group represented by X in general formula (I) and a cured product having a three-dimensional structure formed by hydrolysis and condensation of the mixture of the compound represented by general formula (II) and the compound represented by general formula (III).

Preparation Example 3 (Preparation of Agent for water-repelling treatment 3 (a material for vapor deposition))

Agent for water-repelling treatment 3 as a material for vapor deposition was prepared as described in the following.

As the vessel for the preparation, a 30 cc glass screw bottle manufactured by AS-ONE Company was used, and the rotation speed of a stirrer was set at 500 rpm.

Table 3

| Step | Raw material | Amount | Time of mixing |
|---|---|---|---|
| 1 | KBE 403 + KF 857 | 2 g + 8 g | 24 hours |
| 2 | water-repelling agent + product of Step 1 | 15 g + 3.5 g | 24 hours |
| 3 | product of Step 2 + HFE 7200 | 18.5 g + 3 g | 24 hours |

(Step 1) Preparation of a reaction solution of a silane compound and a silicone oil

KBE 403 (a trade name; manufactured by SHIN-ETSU CHEMICAL Co., Ltd.; 3-glycidoxypropyltriethoxysilane, the molecular weight: 278.4; the refractive index (25°C): 1.425) as the silane compound represented by general formula (II) in an amount of 2 g and 8 g of KF 875 (a trade name; manufactured by SHIN-ETSU CHEMICAL Co., Ltd.; the kinematic viscosity: 65 $mm^2/s$; the refractive index (25°C): 1.411; the equivalent of the functional group: 790 g/mole) having the structure shown in (c) as the silicone oil represented by general formula (III) were mixed, and the resultant mixture was stirred for 24 hours.

The above silane compound had epoxy group, and the above silicone oil had an alkoxy group at both ends of the siloxane chain and amino group at the side chains. Therefore, the amino group and the epoxy group were brought into reaction with each other, and a mixture containing dimethylsiloxanes having an alkoxy group at both ends of the

siloxane chain and at the end of the side chains was formed. About 24 hours was necessary for the reaction to be completed. It was confirmed by the analyses of H, C and NMR that a compound having a molecular weight of about 1,200 to 3,600 was formed.

In Step 2 and Step 3, the same procedures were conducted as those conducted in Preparation Example 1, and Agent for water-repelling treatment 3 was prepared.

The thin film obtained from Agent for water repelling treatment 3 was constituted with a cured product having a three-dimensional structure formed by hydrolysis and condensation of the group represented by X in general formula (I) and a cured product having a three-dimensional structure formed by hydrolysis and condensation of the mixture of the compound represented by general formula (II) and the compound represented by general formula (III).

Comparative Preparation Example 1 (Preparation of Agent for water-repelling treatment 4 (a material for vapor deposition))

A solution obtained by diluting an organosilicon compound having fluorine expressed by the unit formula $C_8F_{17}CH_2CH_2Si(NH_2)_3$ with m-xylene hexachloride to a concentration of 3% by mass (the trade name: KP-801; manufactured by SHIN-ETSU CHEMICAL Co., Ltd.)) was used as Agent for water-repelling treatment 4.

Example 1

A sintered filter made of stainless steel (the diameter of pores: 80 to 100 μm; the diameter: 18 mmϕ; the thickness: 3 mm) impregnated with 0.35 ml of Agent for water-repelling treatment 1 was heated in a dry oven at 80°C for 2 hours and, then, set into an apparatus for vacuum vapor deposition. The entire sintered filter was heated by an electron gun (EB) under the following condition, and a water-repelling film was formed on a plastic lens 1. having an antireflection film. The luminous reflectance of the lens was 0.4%. The results of evaluations with respect to (1) to (5) described above are shown in Table 4.

(1) Degree of vacuum: $3.1\times10^{-4}$ to $8.0\times10^{-4}$ Pa ($2.3\times10^{-6}$ to $6.0\times10^{-6}$ Torr)
(2) Condition of the electron gun

The voltage of acceleration: 6 kV, the applied electric current: 11 mA; the area of irradiation: 3.5x3.5 $cm^2$; the time of vapor deposition: 120 seconds

Example 2

A sintered filter made of stainless steel (the diameter of pores: 80 to 100 μm; the diameter: 18 mmϕ; the thickness: 3 mm) impregnated with 0.35 ml of Agent for water-repelling treatment 1 was heated in a dry oven at 80°C for 2 hours and, then, set into an apparatus for vacuum vapor deposition. The sintered filter was heated by a halogen heater to 650°C in 2 minutes and from 650°C to 680°C in 5 minutes, and a water-repelling film was formed on a plastic lens 1. having an antireflection film. The luminous reflectance of the lens was 0.4%. The results of evaluations with respect to (1) to (5) described above are shown in Table 4.

Example 3

A water-repelling film was formed on a plastic lens 1. having an antireflection film in accordance with the same procedures as those conducted in Example 1 except that Agent for water-repelling treatment 2 was used in place of Agent for water-repelling treatment 1. The luminous reflectance of the lens was 0.4%. The results of evaluations with respect to (1) to (5) described above are shown in Table 4.

Example 4

A water-repelling film was formed on a plastic lens 1. having an antireflection film in accordance with the same procedures as those conducted in Example 2 except that Agent for water-repelling treatment 2 was used in place of Agent for water-repelling treatment 1. The luminous reflectance of the lens was 0.4%. The results of evaluations with respect to (1) to (5) described above are shown in Table 4.

Example 5

A water-repelling film was formed on a plastic lens 1. having an antireflection film in accordance with the same

procedures as those conducted in Example 1 except that Agent for water-repelling treatment 3 was used in place of Agent for water-repelling treatment 1. The luminous reflectance of the lens was 0.4%. The results of evaluations with respect to (1) to (5) described above are shown in Table 4.

Example 6

A water-repelling film was formed on a plastic lens 1. having an antireflection film in accordance with the same procedures as those conducted in Example 2 except that Agent for water-repelling treatment 3 was used in place of Agent for water-repelling treatment 1. The luminous reflectance of the lens was 0.4%. The results of evaluations with respect to (1) to (5) described above are shown in Table 4.

Comparative Example 1

A sintered filter made of stainless steel (the diameter of pores: 80 to 100 μm; the diameter: 18 mmϕ; the thickness: 3 mm) impregnated with 0.4 ml of Agent for water-repelling treatment 4 was heated in a dry oven at 50°C for 1 hour and, then, set into an apparatus for vacuum vapor deposition. The entire sintered filter was heated by an electron gun under the same condition as that in Example 1, and a water-repelling film was formed on a plastic lens 1. having an antireflection film. The luminous reflectance of the lens was 0.4%. The results of evaluations with respect to (1) to (5) described above are shown in Table 4.

Comparative Example 2

A water-repelling film was formed in accordance with the same procedures as those conducted in Example 2 except that a halogen heater was used as the apparatus for heating a sintered filter made of stainless steel impregnated with 0.35 ml of Agent for water-repelling treatment 4 and the time of vapor deposition was 360 seconds. The luminous reflectance of the lens was 0.4%. The results of evaluations with respect to (1) to (5) described above are shown in Table 4.

Table 4

| | Raw material | Process for forming film | Contact angle with water | Appearance | Durability | Abrasion resistance | Dynamic friction coefficient |
|---|---|---|---|---|---|---|---|
| Example 1 | Water-repelling agent-1 | EB heating | 108° | good | 106° | +3.5 | 0.080 |
| Example 2 | Water-repelling agent-1 | halogen heater | 108° | good | 106° | +4.0 | 0.080 |
| Example 3 | Water-repelling agent-2 | EB heating | 108° | good | 106° | +4.0 | 0.085 |
| Example 4 | Water-repelling agent-2 | halogen heater | 108° | good | 106° | +5.0 | 0.085 |
| Example 5 | Water-repelling agent-3 | EB heating | 108° | good | 106° | +2.0 | 0.080 |
| Example 6 | Water-repelling agent-3 | halogen heater | 108° | good | 106° | +3.0 | 0.080 |
| Comparative Example 1 | Water-repelling agent-4 | EB heating | 110° | good | 91° | +11 | 0.250 |
| Comparative Example 2 | Water-repelling agent-4 | halogen heater | 110° | good | 91° | +11 | 0.250 |

As shown by the results of evaluations in Table 4, the water-repelling films in Examples 1 to 6 were more excellent than those in Comparative Examples 1 and 2 with respect to both of the durability and the abrasion resistance. In particular, the water-repelling films in Examples 5 and 6 exhibited more excellent abrasion resistance than that in other Examples. The water-repelling film in Examples 5 and 6 showed smaller falls degrees of property as water-repelling film after the cleaning step than that in other Examples. This result is considered to be obtained by the effect of the presence of alkoxy groups in side chains of the siloxane chain in the water-repelling films in Examples 5 and 6.

INDUSTRIAL APPLICABILITY

When the material for vapor deposition of the present invention is used, the process for producing the optical member in which the water-repelling film exhibits a decreased dynamic friction coefficient, provides excellent slipping feel, easily enables to wipe off attached dirt and exhibits excellent durability and abrasion resistance can be provided. The material can be applied to production of optical members such as spectacle lenses, camera lenses, optical filters attached to displays of computers and windshield glasses of automobiles. In particular, the material is suitable for spectacle lenses.

## Claims

1. A material for vapor deposition which is obtained by mixing an organosilicon compound having an alkyl group substituted with fluorine which is represented by following general formula (I), a silane compound represented by following general formula (II) and a modified silicone oil represented by following general formula (III);
general formula (I) being:

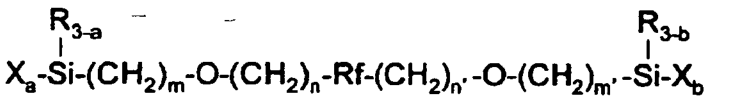

• • • (I)

wherein Rf represents a divalent group having a perfluoropolyalkylene ether structure which comprises a unit represented by $-(C_kF_{2k}O)-$, k representing an integer of 1 to 6, and is linear with no branches, R each independently represent a monovalent hydrocarbon group having 1 to 8 carbon atoms, X each independently represent a hydrolyzable group or a halogen atom, n and n' each represent an integer of 0 to 2, m and m' each represent an integer of 1 to 5, and a and b each represent 2 or 3;
general formula (II) being:

$$R'\text{-}\ Si(OR'')_3 \text{ and/or } Si(OR'')_4 \qquad (II)$$

wherein R' represents an organic group, and R" represents an alkyl group; and
general formula (III) being:

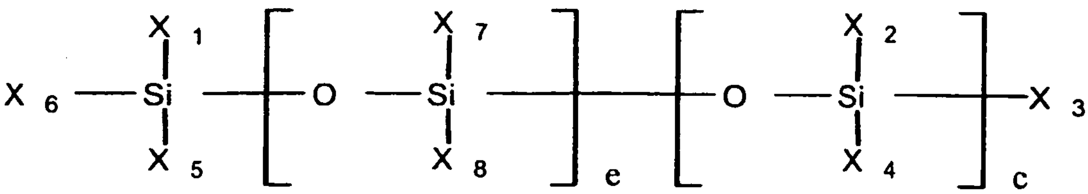

wherein c represents an integer of 1 or greater, e represents an integer of 0 or greater, $X_1$ to $X_8$ each independently represent an organic group, and groups represented by $X_1$ and $X_5$ and/or groups represented by $X_2$ and $X_4$ have methyl group.

2. A material for vapor deposition according to Claim 1, which is a mixture of the organosilicon compound having an alkyl group substituted with fluorine with a reaction product of the silane compound and the modified silicone oil.

3. A material for vapor deposition according to Claim 1, which is diluted with a fluorine-based solvent.

4. A material for vapor deposition according to Claim 3, wherein the fluorine-based solvent is a hydrofluoroether represented by following general formula (IV):

$$CF_3\text{-}(CF_2)_d\text{-}OR''' \qquad (IV)$$

wherein d represents an integer of 1 to 50, and R"' represents methyl group or ethyl group.

5. A process for producing an optical member which comprises a step of solidifying the material for vapor deposition described in Claim 1 by heating and a step of vapor depositing the solidified material for vapor deposition on a substrate made of a plastics by heating by a heating means to form a thin film exhibiting water-repelling property.

6. A process for producing an optical member according to Claim 5, wherein the material for vapor deposition is solidified by heating after impregnating a porous material with the material for vapor deposition.

7. A process for producing an optical member according to Claim 5, wherein the heating means for heating the material for vapor deposition is a resistance heater, a halogen heater or an electron gun.

8. A process for producing an optical member according to Claim 6, wherein the heating means for heating the material for vapor deposition is an electron gun, temperature of the heating is in a range from temperature of start of vaporization to temperature of decomposition of the material for vapor deposition and does not exceed the temperature of decomposition of the material for vapor deposition from start of vaporization to completion of vapor deposition, and vaporization of the material for vapor deposition by heating is completed within 120 seconds after start of the heating.

9. A process for producing an optical member which comprises forming a thin film exhibiting water-repelling property in accordance with the process described in Claim 5 on an antireflection film which is disposed on a substrate made of a plastics.

10. A process for producing an optical member according to Claim 9, wherein an outermost layer in the antireflection film is a layer comprising silicon dioxide as a main component.

11. A process for producing an optical member according to Claim 5, wherein the thin film exhibiting water-repelling property has a refractive index in a range of 1.30 to 1.47 and a thickness in a range of 1 to 20 nm.

12. A process for producing a plastic lens for spectacles which comprises producing the plastic lens for spectacles in accordance with the process for producing an optical member described in Claim 5 wherein the optical member is the plastic lens for spectacles.

13. A plastic lens for spectacles which is produced in accordance with the process described in Claim 12.

**Patentansprüche**

1. Material zur Dampfabscheidung, das durch Mischen einer Organosiliciumverbindung, die eine Alkylgruppe, substituiert mit Fluor, hat, die durch die allgemeine Formel (I) dargestellt wird, einer Silanverbindung, die durch die allgemeine Formel (II) dargestellt wird, und eines modifizierten Silikonöls, das durch die folgende allgemeine Formel (III) dargestellt wird, erhalten wird;
wobei die allgemeine Formel (I) ist:

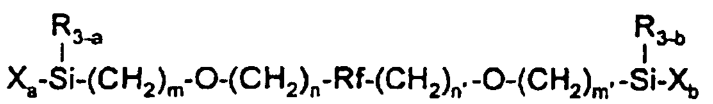
··· (I)

worin Rf eine divalente Gruppe darstellt, die eine Perfluorpolyalkylenether-Struktur hat, welche eine Einheit umfasst, die durch -($C_kF_{2k}O$)- dargestellt wird, worin k eine ganze Zahl von 1 bis 6 darstellt, und die linear ohne Verzweigungen ist; R jeweils unabhängig eine monovalente Kohlenwasserstoffgruppe mit 1 bis 8 Kohlenstoffatomen darstellt; X jeweils unabhängig eine hydrolysierbare Gruppe oder ein Halogenatom darstellt; n und n' jeweils eine ganze Zahl von 0 bis 2 darstellen; m und m' jeweils eine ganze Zahl von 1 bis 5 darstellen und a und b jeweils 2 oder 3 darstellen; die allgemeine Formel (II) ist:

$$R'\text{-}Si(OR'')_3 \text{ und/oder } Si(OR'')_4 \qquad (II)$$

worin R' eine organische Gruppe darstellt und R" eine Alkylgruppe darstellt;
und die allgemeine Formel (III) ist:

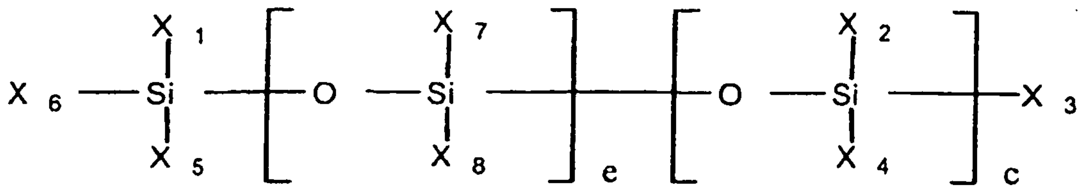

worin c eine ganze Zahl von 1 oder größer darstellt, e eine ganze Zahl von 0 oder größer darstellt, $X_1$ bis $X_8$ jeweils unabhängig eine organische Gruppe darstellen und Gruppen, die durch $X_1$ und $X_5$ dargestellt werden und/oder Gruppen, die durch $X_2$ und $X_4$ dargestellt werden, eine Methylgruppe haben.

**2.** Material zur Dampfabscheidung gemäß Anspruch 1, das ein Gemisch der Organosiliciumverbindung, die eine Alkylgruppe, substituiert mit Fluor, hat, mit einem Reaktionsprodukt der Silanverbindung und des modifizierten Silikonöls ist.

**3.** Material zur Dampfabscheidung gemäß Anspruch 1, das mit einem Lösungsmittel auf Fluorbasis verdünnt ist.

**4.** Material zur Dampfabscheidung gemäß Anspruch 3, wobei das Lösungsmittel auf Fluorbasis ein Hydrofluorether ist, der durch die folgende allgemeine Formel (IV) dargestellt wird:

$$CF_3\text{-}(CF_2)_d\text{-}OR''' \qquad (IV)$$

worin d eine ganze Zahl von 1 bis 50 darstellt und R"' eine Methylgruppe oder Ethylgruppe darstellt.

**5.** Verfahren zur Herstellung eines optischen Elements, das einen Schritt des Verfestigens des Materials zur Dampfabscheidung, das in Anspruch 1 beschrieben ist, durch Erwärmen und einen Schritt der Dampfabscheidung des verfestigten Materials zur Dampfabscheidung auf einem Substrat, das aus einem Kunststoff hergestellt ist, durch Erwärmen mit Hilfe eines Heizmittels unter Bildung eines dünnen Films, der wasserabweisende Eigenschaften aufweist.

**6.** Verfahren zur Herstellung eines optischen Elements gemäß Anspruch 5, wobei das Material zur Dampfabscheidung durch Erwärmen nach Imprägnieren eines porösen Materials mit dem Material zur Dampfabscheidung verfestigt wird.

**7.** Verfahren zur Herstellung eines optischen Elements gemäß Anspruch 5, wobei das Heizmittel zum Erwärmen des Materials zur Dampfabscheidung ein Widerstandsheizgerät, ein Halogenheizgerät oder eine Elektronenkanone ist.

**8.** Verfahren zur Herstellung eines optischen Elements gemäß Anspruch 6, wobei das Heizmittel zum Erwärmen des Materials zur Dampfabscheidung eine Elektronenkanone ist, wobei die Temperatur des Erwärmens im Bereich von der Temperatur des Verdampfungsbeginns bis zur Temperatur der Zersetzung des Materials zur Dampfabscheidung liegt und die Temperatur der Zersetzung des Materials zur Dampfabscheidung von Beginn der Verdampfung bis zur Vervollständigung der Dampfabscheidung nicht übersteigt und die Verdampfung des Materials zur Dampfabscheidung durch Erwärmen innerhalb von 120 Sekunden ab Beginn des Erwärmens vollständig ist.

**9.** Verfahren zur Herstellung eines optischen Elements, das Bilden eines dünnen Films, der wasserabweisende Eigenschaften aufweist, gemäß dem in Beispiel 5 beschriebenen Verfahren auf einem Antireflektionsfilm, der auf einem aus einem Kunststoff hergestellten Substrat abgeschieden ist, umfasst.

**10.** Verfahren zur Herstellung eines optischen Elements gemäß Anspruch 9, wobei die äußerste Schicht im Antireflektionsfilm eine Schicht ist, die Siliciumdioxid als Hauptkomponente umfasst.

**11.** Verfahren zur Herstellung eines optischen Elements gemäß Anspruch 5, wobei der dünne Film, der wasserabweisende Eigenschaften aufweist, einen Brechungsindex im Bereich von 1,30 bis 1,47 und eine Dicke im Bereich von 1 bis 20 nm hat.

**12.** Verfahren zur Herstellung einer Kunststofflinse für Brillen, das Herstellen der Kunststofflinse für Brillen gemäß dem Verfahren zur Herstellung eines optischen Elements, das in Anspruch 5 beschrieben ist, umfasst, wobei das optische Element die Kunststofflinse für Brillen ist.

**13.** Kunststofflinse für Brillen, die gemäß dem in Anspruch 12 beschriebenen Verfahren hergestellt wird.

## Revendications

**1.** Matériau de dépôt en phase vapeur qui est obtenu en mélangeant un composé d'organosilicium comprenant un groupe alkyle substitué par un atome de fluor qui est représenté par la formule générale (I) suivante, un composé de silane représenté par la formule générale (II) suivante et une huile de silicone modifiée représentée par la formule générale (III) suivante ;
la formule générale (I) étant :

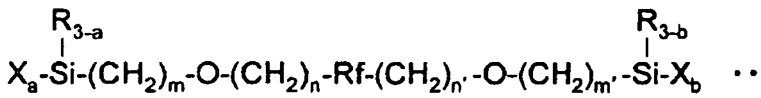 ··· (I)

dans laquelle Rf représente un groupe divalent comprenant une structure de type éther de perfluoropolyalkylène qui comprend un motif représenté par $-(C_kF_{2k}O)-$ où k représente un nombre entier de 1 à 6 et étant linéaire sans ramifications, chaque R représente indépendamment un groupe hydrocarboné monovalent comprenant de 1 à 8 atomes de carbone, chaque X représente indépendamment un groupe hydrolysable ou un atome d'halogène, n et n' représentent chacun un nombre entier de 0 à 2, m et m' représentent chacun un nombre entier de 1 à 5, et a et b représentent chacun 2 ou 3 ;
la formule générale (II) étant :

$$R'\text{-}Si(OR'')_3 \text{ et/ou } Si(OR'')_4 \qquad (II)$$

dans laquelle R' représente un groupe organique et R" représente un groupe alkyle ;
et
la formule générale (III) étant :

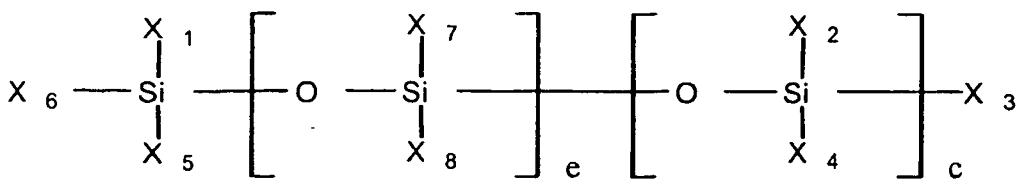

dans laquelle c représente un nombre entier de 1 ou plus, e représente un nombre entier de 0 ou plus, $X_1$ à $X_8$ représentent chacun indépendamment un groupe organique, et les groupes représentés par $X_1$ et $X_5$ et/ou les

groupes représentés par $X_2$ et $X_4$ comprennent un groupe méthyle.

2. Matériau de dépôt en phase vapeur selon la revendication 1, qui est un mélange du composé d'organosilicium comprenant un groupe alkyle substitué par un atome de fluor avec un produit réactionnel du composé de silane et l'huile de silicone modifiée.

3. Matériau de dépôt en phase vapeur selon la revendication 1, qui est dilué avec un solvant à base de fluor.

4. Matériau de dépôt en phase vapeur selon la revendication 3, dans lequel le solvant à base de fluor est un hydrofluoroéther représenté par la formule générale (IV) suivante :

$$CF_3\text{-}(CF_2)_d\text{-}OR''' \qquad (IV)$$

dans laquelle d représente un nombre entier de 1 à 50, et R''' représente un groupe méthyle ou un groupe éthyle.

5. Procédé de production d'un élément optique qui comprend une étape de solidification du matériau de dépôt en phase vapeur décrit dans la revendication 1 par chauffage et une étape de dépôt en phase vapeur du matériau solidifié pour un dépôt en phase vapeur sur un substrat en plastique par chauffage grâce à un moyen de chauffage pour former un film fin exhibant une propriété hydrofuge.

6. Procédé de production d'un élément optique selon la revendication 5, dans lequel le matériau de dépôt en phase vapeur est solidifié par chauffage après l'imprégnation d'un matériau poreux avec le matériau de dépôt en phase vapeur.

7. Procédé de production d'un élément optique selon la revendication 5, dans lequel le moyen de chauffage pour le chauffage du matériau de dépôt en phase vapeur est un appareil de chauffage par résistance, un appareil de chauffage halogène ou un canon à électrons.

8. Procédé de production d'un élément optique selon la revendication 6, dans lequel le moyen de chauffage pour le chauffage du matériau de dépôt en phase vapeur est un canon à électrons, la température du chauffage est comprise dans la plage allant de la température de départ de la vaporisation à la température de décomposition du matériau de dépôt en phase vapeur et n'excède pas la température de décomposition du matériau de dépôt en phase vapeur du départ de la vaporisation jusqu'à l'achèvement du dépôt en phase vapeur, et la vaporisation du matériau de dépôt en phase vapeur par chauffage est achevée dans les 120 minutes qui suivent l'initiation du chauffage.

9. Procédé de production d'un élément optique qui comprend la formation d'un film fin exhibant une propriété hydrophobe selon le procédé décrit dans la revendication 5 sur un film antireflet qui est placé sur un substrat en plastique.

10. Procédé de production d'un élément optique selon la revendication 9, dans lequel une couche la plus externe du film antireflet est une couche comprenant du dioxyde de silicium en tant que composant principal.

11. Procédé de production d'un élément optique selon la revendication 5, dans lequel le film fin exhibant une propriété hydrofuge possède un indice de réfraction compris dans la plage allant de 1,30 à 1,47 et une épaisseur comprise dans la plage allant de 1 à 20 nm.

12. Procédé de production d'une lentille en plastique pour lunettes qui comprend la production de la lentille en plastique pour lunette selon le procédé de production d'un élément optique décrit dans la revendication 5, dans lequel l'élément optique est la lentille en plastique pour lunettes.

13. Lentille en plastique pour lunettes qui est produite selon le procédé décrit dans la revendication 12.

Fig. 1

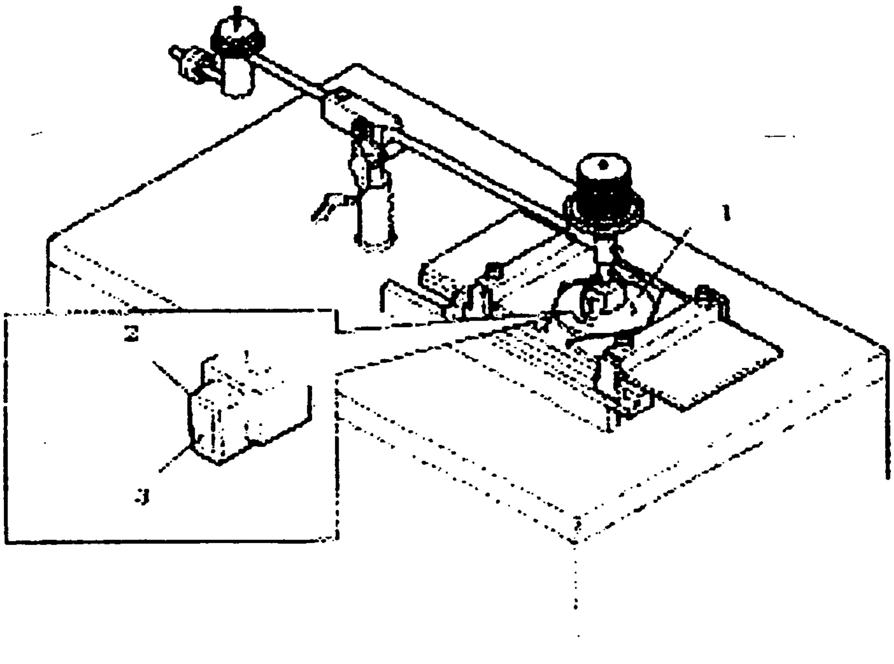

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- US 20040047047 A1
- JP HEISEI51993215905 B
- JP 9157582 A
- JP 9202648 A
- JP 9263728 A
- JP 2004145283 A
- JP 63010640 A